# FASCICULE DE BREVET EUROPEEN

(11) **EP 4 189 302 B1**
(45) Date de publication et mention de la délivrance du brevet: **19.02.2025**
(21) Numéro de dépôt: 21749638.9
(22) Date de dépôt: 27.07.2021
(51) Int. Cl.: F24H 1/00, F24H 9/20, B60H 1/22, F24H 1/10, H05B 3/48, H05B 1/02, H05K 1/00

(54) **DISPOSITIF DE CHAUFFAGE ÉLECTRIQUE D'UN LIQUIDE CALOPORTEUR**
VORRICHTUNG ZUM ELEKTRISCHEN ERWÄRMEN EINER WÄRMETRÄGERFLÜSSIGKEIT
DEVICE FOR ELECTRICALLY HEATING A HEAT TRANSFER LIQUID

(30) Priorité: 29.07.2020 FR 2008052
(43) Date de publication de la demande: 07.06.2023
(73) Titulaire: VALEO SYSTEMES THERMIQUES, 78320 Le Mesnil Saint-Denis (FR)
(72) Inventeur: DELCOURT, Romain, 78322 Le Mesnil-Saint-Denis Cedex (FR); DELETANG, Théo, 78322 Le Mesnil-Saint-Denis Cedex (FR); NIKOUKAR, Shahram, 78322 Le Mesnil-Saint-Denis Cedex (FR); HAMDANI, Abdelmalik, 78322 Le Mesnil-Saint-Denis Cedex (FR)
(74) Mandataire: Valeo Systèmes Thermiques
(86) Numéro de dépôt international: PCT/EP2021/071076
(87) Numéro de publication internationale: WO 2022/023383

(56) Documents cités:
- EP-A1- 3 080 523
- WO-A1-2019/182405
- DE-A1- 102012 013 347
- FR-A1- 3 003 809
- FR-A1- 3 027 558

## Description

Le domaine de la présente invention est celui des dispositifs de chauffage électrique et de circulation d'un liquide caloporteur, notamment pour une installation de ventilation, de chauffage et/ou de climatisation d'un habitacle d'un véhicule automobile. Plus particulièrement, l'invention porte sur les dispositifs de chauffage électrique utilisés pour de telles installations dans des véhicules automobiles, électriques ou hybrides.

Le chauffage de l'air destiné au traitement thermique de l'habitacle d'un véhicule automobile à moteur thermique est assuré par un échange de chaleur entre un flux d'air et un liquide caloporteur, par le biais d'un échangeur thermique. Dans le cas des véhicules hybrides ou électriques, on connait des dispositifs de chauffage électrique qui forment une source de calories et dans lesquels on fait circuler un courant électrique pour monter en température un élément électrique chauffant embarqué dans ce dispositif de chauffage. Le liquide à chauffer traverse ainsi le dispositif de chauffage et est mis au contact de l'élément électrique chauffant, il s'effectue alors un échange de calories entre l'élément électrique chauffant et le liquide destiné au chauffage de l'habitacle, qui chauffe alors à son tour. Un tel dispositif de chauffage électrique est décrit dans le document WO2019/182405.

L'élément électrique chauffant consiste habituellement en une ou plusieurs résistances chauffantes disposées dans une chambre de circulation du liquide à chauffer. Cette chambre de circulation est elle-même reçue dans un boîtier. Plus particulièrement, ce boîtier défini un volume interne dans lequel est reçue la chambre de circulation et dans lequel est également reçue au moins une carte de circuits imprimés qui permet d'assurer la connexion électrique de l'élément électrique chauffant avec une source d'énergie externe au dispositif de chauffage. La connexion entre l'élément électrique chauffant reçu dans la chambre de circulation et la carte de circuits imprimés est par exemple réalisée dans un compartiment du boîtier étanche par rapport à la chambre de circulation et reçu dans le volume interne du boîtier. L'espace disponible dans les installations de chauffage, ventilation et/ou climatisation étant relativement restreint, il existe aujourd'hui un réel besoin de réduire au maximum l'encombrement de ces dispositifs de chauffage électrique. Toutefois, il est également important d'empêcher la formation d'arcs électriques entre la chambre de circulation et la carte de circuits imprimés de ces dispositifs de chauffage électrique qui peuvent être dommageables pour l'ensemble de l'installation.

La présente invention s'inscrit dans ce contexte en proposant un dispositif de chauffage électrique dans lequel la carte de circuits imprimés est agencée au plus près de la chambre de circulation du liquide à chauffer, tout en évitant la formation des arcs électriques évoqués ci-dessus.

Un objet de la présente invention concerne ainsi un dispositif de chauffage électrique d'un liquide caloporteur selon la revendication 1. Ce dispositif comprend au moins un boîtier définissant un volume interne dans lequel sont reçus au moins une chambre de circulation du liquide caloporteur et au moins une carte de circuits imprimés porteuse d'au moins un composant électrique et/ou électronique, la chambre de circulation du liquide caloporteur étant délimitée par au moins une paroi externe, la chambre de circulation du liquide caloporteur logeant au moins un élément électrique chauffant électriquement connecté à l'au moins un composant électrique et/ou électronique porté par la carte de circuit imprimés. Selon l'invention, la carte de circuits imprimés comprend au moins une découpe positionnée en regard de la chambre de circulation du liquide caloporteur. Autrement dit, une projection de la chambre de circulation dans un plan d'extension principal de la carte de circuits imprimés, perpendiculairement à ce plan d'extension principal de la carte de circuits imprimés, s'inscrit au moins partiellement dans la découpe.

Selon l'invention, la chambre de circulation du liquide caloporteur s'étend, au moins partiellement, à travers la découpe formée dans la carte de circuits imprimés. En d'autres termes, le plan d'extension principal de la carte de circuits imprimés coupe, au moins partiellement, la chambre de circulation du liquide caloporteur. Autrement dit, on comprend que cette découpe permet d'agencer la carte de circuits imprimés au plus près de la chambre de circulation, réduisant ainsi l'encombrement total du boîtier et donc du dispositif de chauffage électrique, tout en assurant qu'aucun arc électrique ne soit formé entre la carte de circuits imprimés et la paroi externe de la chambre de circulation.

Selon une caractéristique de la présente invention, une distance inférieure à 3,6 mm est ménagée entre la paroi externe de la chambre de circulation et la carte de circuits imprimés, cette distance étant mesurée selon une droite perpendiculaire à un plan d'extension principal de la carte de circuits imprimés.

Selon une autre caractéristique de la présente invention, au moins deux plots sont formés dans le volume interne du boîtier, la carte de circuits imprimés reposant sur ces au moins deux plots. Selon un exemple de mise en œuvre de l'invention, on pourra prévoir qu'au moins l'un des plots soit issu de matière avec la paroi externe de la chambre de circulation du liquide caloporteur. On entend par « issu de matière », le fait que le plot concerné et la paroi externe de la chambre de circulation du liquide caloporteur forment un ensemble monobloc, c'est-à-dire un unique ensemble qui ne peut être séparé sans entrainer la détérioration du plot et/ou de la paroi externe. Avantageusement, tous les plots sont issus de matière avec la paroi externe de la chambre de circulation.

On comprend de ce qui précède qu'une hauteur de ces plots définit la distance qui sépare la paroi externe de la chambre de circulation de la carte de circuits imprimés. Autrement dit, une hauteur de chacun de ces plots, mesurée selon une droite perpendiculaire au plan d'extension principal de la carte de circuits imprimés est inférieure à 3,6 mm.

Avantageusement, un taraudage peut être formé dans au moins l'un des plots, ce taraudage recevant au moins un dispositif de fixation de la carte de circuits imprimés. Selon une caractéristique de l'invention, au moins un orifice est formé dans la carte de circuits imprimés, cet au moins un orifice étant agencé en regard de l'au moins un plot dans lequel est formé le taraudage, et cet au moins un orifice recevant l'au moins un dispositif de fixation de la carte de circuits imprimés. Selon un exemple de mise en œuvre de l'invention, un filetage est formé dans le taraudage, et l'au moins un dispositif de fixation est une vis.

Selon une caractéristique de l'invention, la paroi externe de la chambre de circulation de liquide caloporteur comprend un matériau thermiquement conducteur.

Selon une caractéristique de l'invention, au moins un commutateur électronique peut être reçu dans le volume interne du boîtier, le volume interne du boîtier comprenant au moins un premier compartiment qui loge, au moins, la chambre de circulation du liquide caloporteur et au moins un deuxième compartiment qui loge l'au moins un commutateur électronique.

Optionnellement, l'au moins un deuxième compartiment peut être délimité, en partie, par une portion de la paroi externe de la chambre de circulation. Cette portion de la paroi externe de la chambre de circulation qui participe à délimiter le deuxième compartiment est appelée « paroi interne ».

Selon un exemple de mise en œuvre de l'invention, au moins une lame élastique peut être reçue dans le volume interne du boîtier, la lame élastique plaquant l'au moins un commutateur électronique contre la chambre de circulation du liquide caloporteur. Selon cet exemple de mise en œuvre de l'invention, la lame élastique peut avantageusement plaquer l'au moins un commutateur électronique contre la paroi externe de la chambre de circulation. Par exemple, la lame élastique comprend au moins un métal ou un alliage de métal. Avantageusement, l'au moins une lame élastique plaque l'au moins un commutateur électronique contre la paroi interne qui participe à délimiter le deuxième compartiment.

Selon un exemple de réalisation de l'invention, l'au moins une lame élastique est portée par une plaque rendue solidaire de la paroi externe de la chambre de circulation par au moins un moyen de fixation. Avantageusement, cette plaque peut être rendue solidaire de la paroi externe de la chambre de circulation par une pluralité de moyens de fixation.

On entend par « lame élastique », une lame adaptée pour reprendre sa position initiale après avoir subi une déformation mécanique. L'au moins un commutateur électronique est ainsi interposé entre l'au moins une lame élastique et la paroi externe de la chambre de circulation, de sorte que l'au moins une lame élastique est déformée. Cette dernière tend à reprendre sa position initiale et, ce faisant, elle génère une force d'appui qui permet de plaquer le commutateur électronique sur la paroi externe de la chambre de circulation du liquide caloporteur. La paroi externe de la chambre de circulation comprenant un matériau thermiquement conducteur, on comprend que ce plaquage permet un échange de chaleur à travers cette paroi externe de la chambre de circulation qui maintient l'au moins un commutateur électronique à une température adéquate, c'est-à-dire une température permettant son fonctionnement sans risque d'endommagement.

Selon une caractéristique de l'invention, une pluralité de lames élastiques peut être reçue dans le volume interne du boîtier, toutes les lames élastiques étant portées par la même plaque. Selon cette caractéristique, une pluralité de commutateurs électroniques peut également être reçue dans le volume interne du boîtier, au moins une lame élastique de la pluralité de lames élastiques plaquant, respectivement, l'un des commutateurs électroniques de la pluralité de commutateurs électroniques. Alternativement, on pourra prévoir que les lames élastiques soient portées par plusieurs plaques distinctes.

Selon l'invention, l'au moins un commutateur électronique est piloté par au moins une piste de commande et au moins une piste de puissance, l'au moins une piste de commande et l'au moins une piste de puissance étant électriquement raccordées à la carte de circuits imprimés.

Avantageusement, le volume interne du boîtier peut comprendre au moins un troisième compartiment dans lequel est réalisée une connexion électrique entre l'au moins un élément électrique chauffant et l'au moins un composant électrique et/ou électronique porté par la carte de circuits imprimés.

Selon une caractéristique de l'invention, la carte de circuits imprimés comprend, dans son plan d'extension principal, au moins une base qui s'étend principalement selon une première droite et au moins une première branche qui s'étend principalement selon une deuxième droite perpendiculaire, ou sensiblement perpendiculaire à la première droite. Autrement dit, on comprend que la première droite et la deuxième droite s'inscrivent toutes deux dans le plan d'extension principal de la carte de circuits imprimés.

Selon un exemple de réalisation de l'invention, la carte de circuits imprimés peut présenter une forme en L.

Optionnellement, la carte de circuits imprimés peut comprendre au moins une deuxième branche qui s'étend principalement selon une troisième droite perpendiculaire, ou sensiblement perpendiculaire à la première droite. En d'autres termes, on comprend que cette troisième droite s'inscrit également dans le plan d'extension principal de la carte de circuits imprimés.

Selon un autre exemple de réalisation de l'invention, la carte de circuits imprimés présente une forme en U.

Selon une configuration de l'invention, la première branche de la carte de circuits imprimés s'étend depuis un premier côté de la base et la deuxième branche s'étend depuis un deuxième côté de la base opposé au premier côté par rapport à la première droite. Selon une autre configuration de l'invention, la première branche de la carte de circuits imprimés et la deuxième branche de la carte de circuits imprimés s'étendent toutes deux depuis un même côté de la base de la carte de circuits imprimés.

Selon un agencement de l'invention, la base de la carte de circuits imprimés peut être positionnée en regard du deuxième compartiment et la découpe formée dans cette carte de circuits imprimés peut être positionnée en regard du premier compartiment. Selon cet agencement de l'invention, on pourra prévoir que la première branche de la carte de circuits imprimés soit positionnée en regard d'au moins un organe de raccordement hydraulique hydrauliquement connecté à la chambre de circulation du liquide caloporteur. La deuxième branche de la carte de circuits imprimés peut quant à elle par exemple être positionnée en regard du troisième compartiment formé dans le volume interne du boîtier.

La présente invention concerne également une installation de chauffage, ventilation et/ou climatisation, comprenant au moins un dispositif de chauffage électrique tel qu'évoqué ci-dessus.

D'autres caractéristiques, détails et avantages ressortiront plus clairement à la lecture de la description détaillée donnée ci-après, à titre indicatif, en relation avec les différentes vues de l'invention illustrées sur les figures suivantes :
La figure 1 illustre, en perspective, un dispositif de chauffage électrique selon l'invention ;
La figure 2 est une vue en coupe transversale du dispositif de chauffage électrique selon l'invention ;
La figure 3 est une vue en coupe longitudinale du dispositif de chauffage électrique selon l'invention ;
La figure 4 illustre, en perspective, une carte de circuits imprimés du dispositif de chauffage électrique selon un premier exemple de réalisation de l'invention ;
La figure 5 illustre, vu de dessus, le dispositif de chauffage électrique selon un deuxième exemple de réalisation de l'invention, le dispositif de chauffage électrique étant représenté ouvert.

Les caractéristiques, variantes et les différentes formes de réalisation de l'invention peuvent être associées les unes avec les autres, selon diverses combinaisons, dans la mesure où elles ne sont pas incompatibles ou exclusives les unes aux autres, tout en restant dans le cadre de l'invention qui est définie par les revendications. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique ou pour différencier l'invention par rapport à l'état de la technique antérieur, tout en restant dans le cadre de l'invention qui est définie par les revendications.

Sur les figures, les dénominations longitudinale, transversale, latérale, gauche, droite, dessus, dessous, se réfèrent à l'orientation, dans un trièdre L, V, T d'un boîtier 110 d'un dispositif de chauffage électrique 100 selon l'invention. Dans ce repère, un axe longitudinal L représente une direction longitudinale, un axe transversal T représente une direction transversale, et un axe vertical V représente une direction verticale de l'objet considéré. Dans ce repère, une coupe verticale correspond à une coupe réalisée selon un plan transversal et vertical, c'est-à-dire un plan dans lequel s'inscrivent l'axe transversal T et l'axe vertical V du trièdre. Une coupe longitudinale désigne quant à elle une coupe réalisée selon un plan longitudinal et vertical, c'est-à-dire un plan dans lequel s'inscrivent l'axe longitudinal L et l'axe vertical V. Une coupe transversale désigne enfin une coupe réalisée selon un plan transversal et longitudinal, c'est-à-dire un plan dans lequel s'inscrivent l'axe transversal T et l'axe longitudinal L.

Dans la description qui suit les termes « dispositif de chauffage électrique » et « dispositif de chauffage » seront utilisés sans distinction.

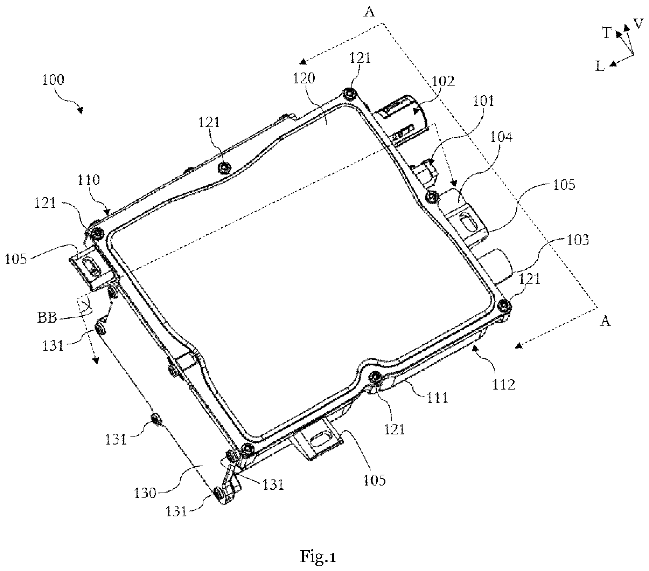

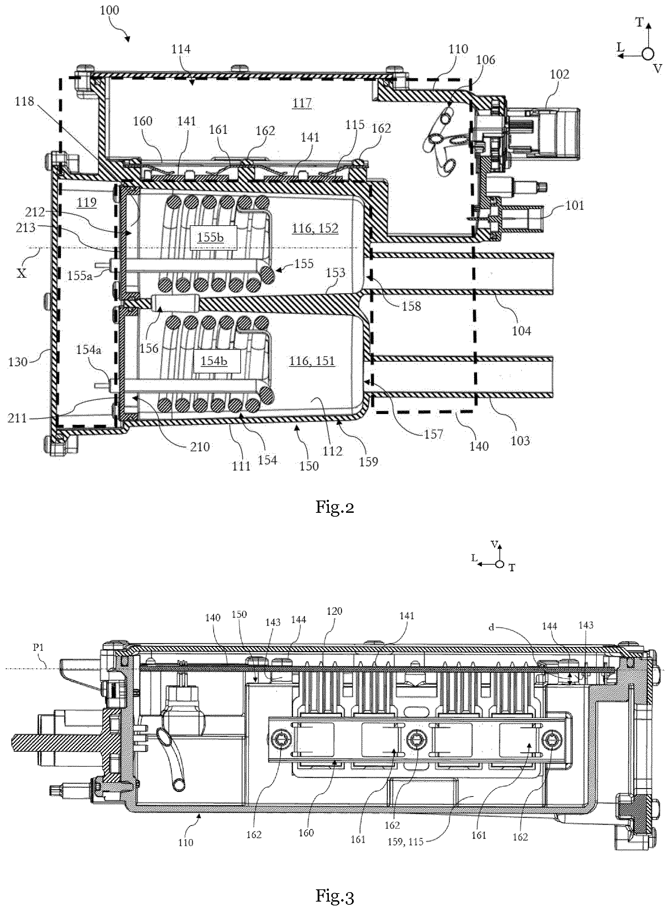

La figure 1 illustre, en perspective, un dispositif de chauffage 100 selon la présente invention. Ce dispositif de chauffage 100 comprend au moins un boîtier 110 formé d'au moins une paroi périphérique 111 qui présente au moins une ouverture fermée par un capot 130, une paroi de fond 112, une paroi supérieure qui présente un orifice recouvert par un couvercle 120. Le boîtier 110, et plus particulièrement les parois de ce boîtier 110, délimite un volume interne - par exemple visible sur la figure 2 - qui reçoit au moins une chambre de circulation d'un liquide caloporteur et au moins une carte de circuits imprimés.

Le boîtier 110 présente au moins une face avant formée, au moins, par une première portion de la paroi périphérique 111 et par le capot 130, une face arrière formée, au moins, par une deuxième portion de la paroi périphérique 111, une face supérieure formée, au moins, par le couvercle 120, une face inférieure formée, au moins, par la paroi de fond 112 et au moins deux faces latérales, qui relient, respectivement, la face supérieure, la face inférieure, la face avant et la face arrière du boîtier. Plus particulièrement, une première face latérale est formée par une troisième portion de la paroi périphérique 111 qui s'étend dans un premier plan longitudinal et une deuxième face latérale est formée par une quatrième portion de la paroi périphérique qui s'étend dans un deuxième plan longitudinal distinct et parallèle au premier plan longitudinal.

Afin de permettre le raccordement de la carte de circuits imprimés à une source d'énergie externe, au moins un connecteur de commande 101 et au moins un connecteur de puissance 102 sont agencés de sorte à former saillie de la face arrière du boîtier 110, c'est-à-dire de la deuxième portion de la paroi périphérique 111 formant cette face arrière. Un organe de raccordement hydraulique d'entrée 103 et un organe de raccordement hydraulique de sortie 104 sont également formés sur la face arrière du boîtier 110 et sont respectivement configurés pour permettre l'acheminement et l'évacuation de liquide caloporteur dans et hors de la chambre de circulation. Plus particulièrement, l'organe de raccordement d'entrée 103 est connecté d'une part à un circuit de liquide caloporteur et d'autre part à une bouche d'admission formée dans une paroi de la chambre de circulation et l'organe de raccordement hydraulique de sortie 104 est quant à lui raccordé, d'une part à une bouche d'évacuation formée dans une paroi de la chambre de circulation et d'autre part au circuit de liquide caloporteur. Autrement dit, on comprend que le dispositif de chauffage 100 selon l'invention est adapté pour être agencé sur un circuit de liquide caloporteur.

Selon l'exemple illustré sur les figures, l'organe de raccordement hydraulique d'entrée 103 et l'organe de raccordement hydraulique de sortie 104 prennent la forme de tubulures, c'est-à-dire des structures cylindriques creuses.

Le couvercle 120 est maintenu sur la paroi supérieure par au moins un élément de fixation 121, avantageusement par une pluralité d'éléments de fixation 121. Afin d'assurer un maintien pérenne du couvercle 120 sur la paroi supérieure, une distance inférieure ou égale à 70 mm est respectée entre deux éléments de fixation 121 successifs. Cette distance est mesurée, entre deux éléments de fixation 121 successifs, parallèlement à une droite qui s'inscrit dans un plan d'extension principal du couvercle 120, c'est-à-dire un plan transversal. Le capot 130 est quant à lui maintenu sur la paroi périphérique 111 par au moins un organe de fixation 131, avantageusement par une pluralité d'organes de fixation 131. Afin d'assurer un maintien pérenne du capot 130 sur la paroi périphérique 111, une distance inférieure ou égale à 70 mm est respectée entre deux organes de fixation 131 successifs, cette distance étant mesurée selon une droite qui s'inscrit dans un plan d'extension principal du capot 130, c'est-à-dire un plan vertical.

Le boîtier 110 comprend également au moins une patte de fixation 105 adaptée pour permettre la fixation du dispositif de chauffage électrique 100, par exemple dans un véhicule. Selon l'exemple illustré, le boîtier 110 comprend plus particulièrement trois pattes de fixation 105 réparties sur la paroi périphérique 111. Une première patte de fixation 105 est ainsi formée sur la première portion de la paroi périphérique 111 qui participe à former la face avant du boîtier 110, une deuxième patte de fixation 105 est formée sur la troisième portion de la paroi périphérique 111 qui forme la première face latérale du boîtier 110, et une troisième patte de fixation 105 est quant à elle formée sur la face arrière du boîtier 110, c'est-à-dire sur la deuxième portion de la paroi périphérique 111 qui forme cette face arrière.

En référence à la figure 2, nous allons maintenant plus amplement décrire un exemple d'agencement interne du boîtier 110 du dispositif de chauffage 100 selon l'invention. Cette figure 2 illustre ainsi le dispositif de chauffage 100 vue selon une coupe transversale réalisée selon un plan AA illustré sur la figure 1.

Tel que précédemment évoqué, le boîtier 110 défini un volume interne 114 dans lequel sont reçus au moins la chambre de circulation 150 et la carte de circuits imprimés 140 - illustrée schématiquement sur la figure 2. Une paroi interne 115 sépare ce volume interne 114 en au moins un premier compartiment 116 et au moins un deuxième compartiment 117. Une paroi de séparation 118 est également agencée dans le volume interne 114 de sorte à délimiter un troisième compartiment 119. La paroi de séparation 118 présente au moins une ouverture 210 qui met en communication la chambre de circulation 150 et le troisième compartiment 119. Tel que détaillé ci-après, cette au moins une ouverture 210 est obstruée par au moins une plaque de fermeture 211.

Le premier compartiment 116 est ainsi délimité, au moins, par une première partie de la paroi périphérique 111, par une première partie de la paroi de fond 112, par la paroi interne 115, par la paroi de séparation 118 et par une première partie du couvercle. Le deuxième compartiment 117 est délimité, au moins, par une deuxième partie de la paroi périphérique 111, par une deuxième partie de la paroi de fond 112, par la paroi interne 115 et par au moins une deuxième partie du couvercle 120. Le troisième compartiment 119 est quant à lui délimité par la paroi de séparation 118, par une troisième partie de la paroi périphérique 111, par une troisième partie du couvercle et par le capot 130. Les premières, deuxièmes et troisièmes parties des éléments susmentionnés sont distinctes les unes des autres.

La chambre de circulation 150 est reçue dans le premier compartiment 116. Plus particulièrement, selon l'exemple illustré ici, cette chambre de circulation 150 est délimitée par une paroi externe 159 formée d'au moins la première partie de la paroi de fond 112 du boîtier 110, la paroi interne 115, la paroi de séparation 118, la première partie de la paroi périphérique 111 et d'une paroi supérieure - non visible sur cette coupe.

On comprend que la première partie du couvercle qui participe à délimiter le premier compartiment 116 est agencée en regard de la paroi supérieure de la chambre de circulation 150.

Selon l'exemple illustré ici, la chambre de circulation 150 présente au moins un premier espace interne 151 et au moins un deuxième espace interne 152 séparés l'un de l'autre, au moins partiellement, par une cloison 153. Tel que représenté, au moins un premier élément électrique chauffant 154 est reçu dans le premier espace interne 151 et au moins un deuxième élément électrique chauffant 155 est reçu dans le deuxième espace interne 152 de cette chambre de circulation 150. Selon l'exemple illustré, la paroi de séparation 118 qui participe à délimiter la chambre de circulation 150 présente une première ouverture 210 et une deuxième ouverture 212 qui débouchent, respectivement, sur le premier espace interne 151 et sur le deuxième espace interne 152. Ces ouvertures 210, 212 sont respectivement fermées par une première plaque de fermeture 211 et par une deuxième plaque de fermeture 213. Selon l'exemple illustré les premier et deuxième éléments électriques chauffants 154, 155 sont respectivement formés d'une résistance électrique chauffante, par exemple une résistance blindée. Un passage 156 est formé dans la cloison 153 de sorte à permettre la circulation de liquide caloporteur dans l'ensemble de la chambre de circulation 150, c'est-à-dire à la fois dans le premier espace interne 151 et dans le deuxième espace interne 152. Par exemple, ce passage 156 peut prendre la forme d'une découpe rectangulaire, ou sensiblement rectangulaire, formée dans la cloison 153.

Le premier élément électrique chauffant 154 comprend au moins un premier segment terminal 154a, au moins un deuxième segment terminal - non visible sur la coupe de la figure 2 - et une portion intermédiaire 154b qui relie le premier segment terminal 154a au deuxième segment terminal. Le premier segment terminal 154a et le deuxième segment terminal sont adaptés pour permettre l'alimentation du premier élément électrique chauffant 154 en énergie électrique, et ainsi permettre à cet élément électrique chauffant 154 de chauffer. La portion intermédiaire 154b est quant à elle au moins partiellement enroulée autour d'un axe d'extension principal X. Le premier segment terminal 154a et le deuxième segment terminal s'étendent, respectivement, selon une direction parallèle à l'axe d'extension principal X. Avantageusement, le premier segment terminal 154a et le deuxième segment terminal s'étendent d'un même côté du premier élément électrique chauffant 154.

L'enroulement de la portion intermédiaire 154b peut par exemple être un enroulement hélicoïdal, c'est-à-dire un enroulement selon un mouvement régulier combinant une translation et une rotation autour de l'axe d'extension principal X.

Selon l'exemple illustré ici, le premier élément électrique chauffant 154 et le deuxième élément électrique chauffant 155 présentent des structures identiques si bien que la description qui vient d'être donnée du premier élément électrique chauffant 154 s'applique mutatis mutandis au deuxième élément électrique chauffant 155.

La bouche d'admission 157 du liquide caloporteur et la bouche d'évacuation 158 de ce liquide caloporteur sont toutes deux formées dans la première partie de la paroi périphérique 111 qui participe à délimiter le premier compartiment 116. Tel que représenté, la bouche d'admission 157 à laquelle est hydrauliquement connecté l'organe de raccordement hydraulique d'entrée 103 est réalisée de sorte à déboucher dans le premier espace interne 151 de la chambre de circulation 150 et la bouche d'évacuation 158 du liquide caloporteur à laquelle est hydrauliquement connecté l'organe de raccordement hydraulique de sortie 104 est quant à elle réalisée de sorte à déboucher dans le deuxième espace interne 152 de cette chambre de circulation 150. Avantageusement, le fait de réaliser ces bouches d'admission 157 et d'évacuation 158 de sorte à ce qu'elles débouchent, respectivement, dans le premier espace interne 151 et dans le deuxième espace interne 152 permet de s'assurer que le liquide caloporteur circule dans ces deux espaces internes 151, 152 avant de quitter la chambre de circulation 150, améliorant ainsi l'efficacité du dispositif de chauffage 100 selon l'invention. Autrement dit, un tel agencement permet au liquide caloporteur d'être au contact des deux éléments électriques chauffants 154, 155 sur une durée minimale qui permet d'assurer que le liquide caloporteur quitte la chambre de circulation 150 à une température minimale prédéterminée.

Avantageusement, la paroi de fond 112, la paroi interne 115, la paroi de séparation 118, la paroi supérieure, la première partie de la paroi périphérique 111 et la cloison 153 peuvent être issues de matière, c'est-à-dire former un unique ensemble qui ne peut être séparé sans entrainer la détérioration de la paroi de fond 112, de la paroi interne 115, de la paroi de séparation 118, de la paroi périphérique 111 de la paroi supérieure et/ou de la cloison 153.

Tel qu'évoqué ci-dessus, le volume interne 114 du boîtier 110 loge également la carte de circuits imprimés 140 schématiquement illustrée en traits discontinus sur la figure 2. Cette carte de circuits imprimés 140 est électriquement raccordée à une source d'énergie électrique externe par l'intermédiaire du connecteur de commande 101 et du connecteur de puissance 102, ainsi qu'aux deux éléments électriques chauffants 154, 155 reçus dans la chambre de circulation 150 du liquide caloporteur par l'intermédiaire de leurs segments terminaux respectifs.

Ainsi, au moins un élément de connexion électrique 106 s'étend depuis le connecteur de puissance 102, dans le deuxième compartiment 117 ménagé dans le volume interne 114 du boîtier 110. Bien que la coupe illustrée sur la figure 2 ne le rende pas visible, on comprend qu'au moins un autre élément de connexion électrique s'étend depuis le connecteur de commande 101, dans ce deuxième compartiment 117, ces éléments de connexion électrique étant adaptés pour permettre le raccordement électrique entre le connecteur depuis lequel ils s'étendent respectivement et la carte de circuits imprimés 140. Avantageusement, ce raccordement électrique est ainsi réalisé dans le deuxième compartiment 117.

Selon l'exemple illustré, au moins un commutateur électronique 141 est également reçu dans le deuxième compartiment 117. Cet au moins un commutateur électronique 141 est raccordé électriquement à la carte de circuits imprimés 140, et plus particulièrement à au moins une piste de commande et une piste de puissance formées sur la carte de circuits imprimés 140. Tel que représenté, cet au moins un commutateur électronique 141 est plus particulièrement agencé au contact de la paroi interne 115 qui participe à définir le deuxième compartiment 117. Par exemple, la paroi externe 159 de la chambre de circulation 150, et en particulier la paroi interne 115 qui participe à former cette paroi externe 159 de la chambre de circulation 150, peut comprendre un matériau thermiquement conducteur. Avantageusement, un transfert de chaleur peut ainsi s'opérer entre le liquide caloporteur qui circule dans la chambre de circulation 150 et l'au moins un commutateur électronique 141 agencé au contact de la paroi interne 115.

Avantageusement, une plaque 160 équipée d'au moins une lame élastique 161 permet de plaquer le commutateur électronique 141 contre la paroi interne 115. On entend ici par « lame élastique » une lame adaptée pour reprendre sa position initiale après avoir subi une déformation mécanique.

Tel que représenté, cette plaque 160 est ainsi positionnée de sorte que l'au moins une lame élastique 161 qu'elle porte soit au contact de l'au moins un commutateur électronique 141. Avantageusement, la plaque 161 comprend au moins autant de lames élastiques 161 que le dispositif de chauffage 100 comprend de commutateurs électroniques.

Tel que représenté, au moins un moyen de fixation 162 permet de rendre la plaque 160 solidaire de la paroi interne 115. Par exemple, l'au moins un moyen de fixation 162 peut être une vis. Avantageusement, une pluralité de moyens de fixation 162 permettent de rendre la plaque 160 solidaire de la paroi interne 115. On comprend de la figure 2 que l'au moins un commutateur électronique 141 est interposé entre la paroi interne 115 et l'au moins une lame élastique 161. Cette au moins une lame élastique 161 est ainsi déformée par la présence de cet au moins un commutateur électronique 141 et tend à reprendre sa position initiale. Ce faisant, l'au moins une lame élastique 161 génère une force d'appui qui plaque l'au moins un commutateur électronique 141 contre la paroi interne 115, assurant ainsi un contact permanent entre cet au moins un commutateur électronique 161 et la paroi interne 115. Ce contact permet, avantageusement, qu'un échange de chaleur s'opère entre le liquide caloporteur qui circule dans la chambre de circulation 150 et l'au moins un commutateur électronique 141. Ainsi, l'au moins un commutateur électronique 141 transmet des calories au liquide caloporteur et participe au chauffage de ce liquide caloporteur, tout en maintenant une température acceptable permettant son bon fonctionnement.

La chambre de circulation 150 du liquide caloporteur est étanche par rapport au reste du volume interne du boîtier 110. Autrement dit, cette chambre de circulation 150 est étanche, au moins, par rapport au deuxième compartiment 117, ce qui assure la sécurité de la connexion électrique qui y est réalisée.

La carte de circuits imprimés 140 est en outre électriquement raccordée aux éléments électriques chauffants 154, 155 reçus dans la chambre de circulation 150 du liquide caloporteur. A cet effet, le premier segment terminal 154a et le deuxième segment terminal du premier élément électrique chauffant 154 traversent la première plaque de fermeture 211 qui ferme la première ouverture 210 formée dans la paroi de séparation 118 et le premier segment terminal 155a et le deuxième segment terminal du deuxième élément électrique chauffant 155 traversent quant à eux la deuxième plaque de fermeture 213 qui ferme la deuxième ouverture 212 formée dans cette paroi de séparation 118. Autrement dit, une extrémité libre du premier segment terminal 154a du premier élément électrique chauffant 154, une extrémité libre du deuxième segment terminal du premier élément électrique chauffant 154, une extrémité libre du premier segment terminal 155a du deuxième élément électrique chauffant 155 et une extrémité libre du deuxième segment terminal du deuxième élément électrique chauffant 155 s'étendent toutes les quatre dans le troisième compartiment 119, permettant ainsi le raccordement électrique de ces segments terminaux à la carte de circuits imprimés 140.

La figure 3 illustre une vue en coupe réalisée selon un plan longitudinal BB représenté sur la figure 1.

Cette figure 3 rend ainsi particulièrement visible la plaque 160 porteuse de l'au moins une lame élastique 161 qui permet de plaquer l'au moins un commutateur électronique 141 contre la paroi interne 115. Selon l'exemple illustré, la plaque 160 est maintenue contre la paroi interne 115 grâce à trois moyens de fixation 162, deux lames élastiques 161 étant formées entre deux moyens de fixation 162 successifs.

La carte de circuits imprimés 140 repose sur au moins deux plots 143, avantageusement plus de deux plots 143, qui s'étendent depuis les parois qui définissent la chambre de circulation 150. La figure 3 rend notamment visible deux plots 143 qui s'étendent, respectivement, depuis la paroi interne 115. Avantageusement, au moins un de ces plots 143 comprend un taraudage adapté pour recevoir un dispositif de fixation 144. Selon l'exemple illustré un filetage est formé dans le taraudage et le dispositif de fixation 144 est une vis. Il est entendu qu'il ne s'agit que d'un exemple de réalisation de l'invention et que tout autre dispositif de fixation peut être utilisé sans sortir du contexte de la présente invention.

Tel qu'évoqué précédemment, une distance d inférieure à 3,6 mm est ménagée entre la paroi externe 159 de la chambre de circulation 150 et la carte de circuits imprimés 140. Tel que représenté, cette distance d est mesurée parallèlement à une droite perpendiculaire à un plan d'extension principal P1 de la carte de circuits imprimés 140. Autrement dit, cette distance d est mesurée parallèlement à l'axe vertical V.

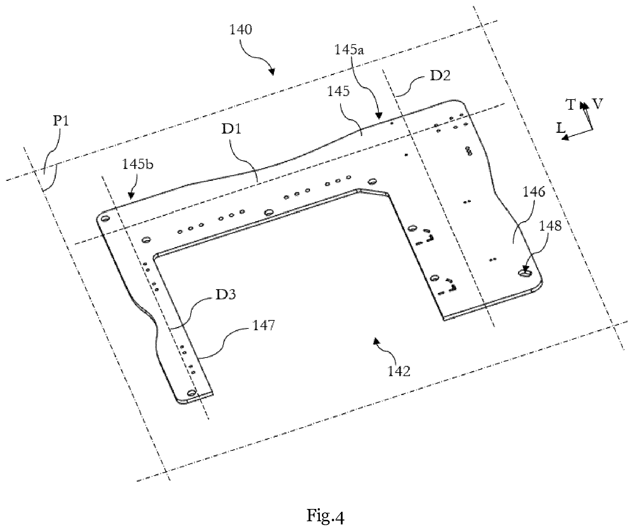

La figure 4 illustre, en perspective, la carte de circuits imprimés 140 selon un premier exemple de réalisation de la présente invention. Tel que représenté, au moins une découpe 142 est formée dans la carte de circuits imprimés 140. Tel que schématiquement illustré sur la figure 2, cette au moins une découpe 142 est agencée en regard de la chambre de circulation 150. Selon l'invention, la chambre de circulation 150 s'étend, au moins partiellement, à travers cette découpe 142. Autrement dit, un plan d'extension principal de la carte de circuit imprimés 140 coupe, au moins partiellement, cette chambre de circulation 150.

Un tel agencement permet avantageusement de réduire un encombrement total du dispositif de chauffage 100, tout en évitant la formation d'arcs électriques entre la carte de circuits imprimés 140 et la paroi externe de la chambre de circulation 150. Selon le premier exemple de réalisation illustré sur la figure 4, la carte de circuits imprimés prend une forme en U. Autrement dit, la carte de circuits imprimés 140 présente au moins, dans son plan d'extension principal P1, une base 145 de laquelle s'étendent au moins une première branche 146 et au moins une deuxième branche 147. Tel qu'illustré, la base 145 s'étend, majoritairement selon un première direction D1, la première branche 146 s'étend, majoritairement selon une deuxième direction D2 perpendiculaire, ou sensiblement perpendiculaire, à la première direction D1 et la deuxième branche 147 s'étend, majoritairement selon une troisième direction D3 perpendiculaire, ou sensiblement perpendiculaire, à la première direction D1. Il est entendu que la première direction D1, la deuxième direction D2 et la troisième direction D3 s'inscrivent toutes trois dans le plan d'extension principal P1 de la carte de circuits imprimés 140. Selon l'exemple illustré, ce plan d'extension principal P1 est un plan transversal lorsque la carte de circuits imprimés 140 est reçue dans le boîtier du dispositif de chauffage électrique.

Selon l'exemple illustré ici, la première branche 146 s'étend depuis un premier côté 145a de la base 145 et la deuxième branche 147 s'étend quant à elle depuis un deuxième côté 145b de cette base 145, le premier côté 145a et le deuxième côté 145b de la base 145 étant opposés l'un à l'autre par rapport à la première droite D1 d'extension principal de la base 145. Selon une alternative non illustrée ici, la première branche et la deuxième branche peuvent s'étendre depuis un même côté de la base.

Par exemple, la base 145 peut être agencée en regard du deuxième compartiment décrit ci-dessus et la deuxième branche 147 en regard du troisième compartiment. Selon le premier exemple de réalisation, la deuxième branche 147 de la carte de circuits imprimés peut quant à elle être agencée en regard des organes de raccordement hydrauliques d'entrée et de sortie. Autrement dit, la découpe 142 formée dans cette carte de circuits imprimés 140 est positionnée en regard du premier compartiment qui reçoit la chambre de circulation du liquide caloporteur.

En outre, au moins un orifice 148 est formé dans la carte de circuits imprimés 140, cet au moins un orifice 148 étant adapté pour être agencé en regard du taraudage ménagé dans au moins l'un des plots décrits précédemment, et cet au moins un orifice 148 est adapté pour recevoir l'au moins un dispositif de fixation qui permet de rendre la carte de circuits imprimés 140 solidaire de la paroi externe de la chambre de circulation. Selon l'exemple illustré, une pluralité d'orifices 148 est formée sur la carte de circuits imprimés 140. Avantageusement, au moins autant d'orifices 148 sont formés dans la carte de circuits imprimés 140 que de taraudages sont formés dans les plots, chaque orifice 148 étant adapté pour être agencé en regard de l'un de ces taraudages.

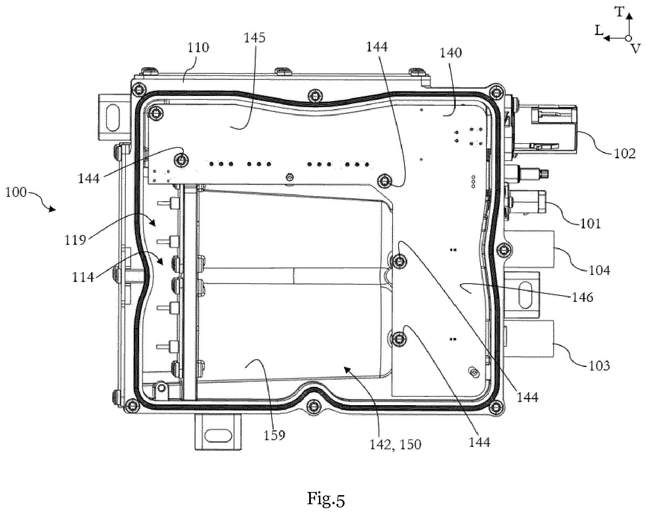

La figure 5 illustre enfin le dispositif de chauffage électrique 100 selon l'invention, représenté dépourvu de son couvercle. Autrement dit, cette figure 5 rend particulièrement visible la carte de circuits imprimés 140, ici réalisée selon un deuxième exemple de réalisation.

Selon ce deuxième exemple de réalisation de l'invention, la carte de circuits imprimés 140 présente une forme en L, c'est-à-dire qu'elle comprend la base 145 et la première branche 146 qui s'étend depuis cette base 145. Tel que représenté, la base 145 est ainsi agencée en regard du deuxième compartiment dans lequel est réalisée la connexion électrique entre la carte de circuits imprimés 140 et les connecteurs de commande et de puissance 101, 102 et la première branche 146 est quant à elle agencée en regard, au moins partiellement, de l'organe de raccordement hydraulique d'entrée 103 et de l'organe de raccordement hydraulique de sortie 104. De façon similaire à ce qui a été décrit ci-dessus, la découpe 142 formée dans la carte de circuits imprimés 140 est agencée en regard de la chambre de circulation 150.

Également, cette figure 5 rend visible les dispositifs de fixation 144 qui permettent d'assurer le maintien de la carte de circuits imprimés 140 en position dans le volume interne 114 du boîtier 110.

On comprend de ce qui précède que la présente invention propose un dispositif de chauffage électrique dans lequel la carte de circuits imprimés est agencée au plus près de la chambre de circulation du liquide caloporteur, permettant ainsi de réduire l'encombrement général du dispositif de chauffage électrique, tout en évitant la formation d'arcs électriques entre la paroi externe de la chambre de circulation et la carte de circuits potentiellement dangereux.

La présente invention ne saurait toutefois se limiter aux moyens et configurations décrits et illustrés ici et elle s'étend également à tout moyen et configuration équivalents ainsi qu'à toute combinaison techniquement opérante de tels moyens, dans le cadre de l'invention qui est définie par les revendications. En particulier la forme et la disposition de la carte de circuits imprimés pourraient être modifiées sans nuire à l'invention qui est définie par les revendications, dans la mesure où elles remplissent les fonctionnalités décrites dans le présent document.

## Revendications

1. Dispositif de chauffage électrique (100) d'un liquide caloporteur, comprenant au moins un boîtier (110) définissant un volume interne (114) dans lequel sont reçus au moins une chambre de circulation (150) du liquide caloporteur et au moins une carte de circuits imprimés (140) porteuse d'au moins un composant électrique et/ou électronique, la chambre de circulation (150) du liquide caloporteur étant délimitée par au moins une paroi externe (159), la chambre de circulation (150) du liquide caloporteur logeant au moins un élément électrique chauffant (154, 155) électriquement connecté à l'au moins un composant électrique et/ou électronique porté par la carte de circuits imprimés (140), la carte de circuits imprimés (140) comprenant au moins une découpe (142) positionnée en regard de la chambre de circulation (150) du liquide caloporteur, **caractérisé en ce que** la chambre de circulation (150) s'étend, au moins partiellement, à travers la découpe (142).

2. Dispositif de chauffage électrique (100) la revendication 1, dans lequel au moins un commutateur électronique (141) est reçu dans le volume interne (114) du boîtier (110), dans lequel le volume interne (114) du boîtier (110) comprend au moins un premier compartiment (116) qui loge, au moins, la chambre de circulation (150) du liquide caloporteur et au moins un deuxième compartiment (117) qui loge l'au moins un commutateur électronique (141).

3. Dispositif de chauffage électrique (100) selon la revendication précédente, dans lequel le volume interne (114) du boîtier (110) comprend au moins un troisième compartiment (119) dans lequel est réalisée une connexion électrique entre l'au moins un élément électrique chauffant (154, 155) et l'au moins un composant électrique et/ou électronique porté par la carte de circuits imprimés (140).

4. Dispositif de chauffage électrique (100) selon l'une quelconque des revendications précédentes, dans lequel la carte de circuits imprimés (140) comprend, dans son plan d'extension principal (P1), au moins une base (145) qui s'étend principalement selon une première droite (D1) et au moins une première branche (146) qui s'étend principalement selon une deuxième droite (D2) perpendiculaire, ou sensiblement perpendiculaire à la première droite (D1).

5. Dispositif de chauffage électrique (100) selon l'une quelconque des revendications précédentes, dans lequel la carte de circuits imprimés (140) présente une forme en L.

6. Dispositif de chauffage électrique (100) selon la revendication 4, dans lequel la carte de circuits imprimés (140) comprend, dans son plan d'extension principal (P1), au moins une deuxième branche (147) qui s'étend principalement selon une troisième droite (D3) perpendiculaire, ou sensiblement perpendiculaire à la première droite (D1).

7. Dispositif de chauffage électrique (100) selon l'une quelconque des revendications 1 à 4 ou 4, dans lequel la carte de circuits imprimés (140) présente une forme en U.

8. Dispositif de chauffage électrique (100) selon la revendication 76ou selon la revendication 6 prise en combinaison avec la revendication 7, dans lequel la première branche (146) de la carte de circuits imprimés (140) s'étend depuis un premier côté (145a) de la base (145) et dans lequel la deuxième branche (147) s'étend depuis un deuxième côté (145b) de la base (145) opposé au premier côté par rapport à la première droite (D1).

9. Dispositif de chauffage électrique (100) selon l'une quelconque des revendications précédentes prise en combinaison avec les revendications 2 ou 3 et 4, dans lequel la base (145) de la carte de circuits imprimés (140) est positionnée en regard du deuxième compartiment (117), et dans lequel la découpe (142) formée dans la carte de circuits imprimés est positionnée en regard du premier compartiment (116).

## Patentansprüche

1. Vorrichtung zum elektrischen Erwärmen (100) einer Wärmeträgerflüssigkeit, umfassend mindestens ein Gehäuse (110), das ein Innenvolumen (114) definiert, in dem mindestens eine Zirkulationskammer (150) für die Wärmeträgerflüssigkeit und mindestens eine Leiterplatte (140), die mindestens ein elektrisches und/oder elektronisches Bauteil trägt, untergebracht sind, wobei die Zirkulationskammer (150) der Wärmeträgerflüssigkeit durch mindestens eine Außenwand (159) begrenzt ist, die Zirkulationskammer (150) der Wärmeträgerflüssigkeit mindestens ein elektrisches Erwärmungselement (154, 155) aufnimmt, das elektrisch mit dem mindestens einen elektrischen und/oder elektronischen Bauteil verbunden ist, das von der Leiterplatte (140) getragen wird, wobei die Leiterplatte (140) mindestens einen Ausschnitt (142) umfasst, der gegenüber der Zirkulationskammer (150) der Wärmeträgerflüssigkeit positioniert ist, **dadurch gekennzeichnet, dass** sich die Zirkulationskammer (150) mindestens teilweise durch den Ausschnitt (142) hindurch erstreckt.

2. Vorrichtung zum elektrischen Erwärmen (100) nach Anspruch 1, wobei mindestens ein elektronischer Schalter (141) in dem Innenvolumen (114) des Gehäuses (110) untergebracht ist, wobei das Innenvolumen (114) des Gehäuses (110) mindestens ein erstes Fach (116), das mindestens die Zirkulationskammer (150) der Wärmeträgerflüssigkeit aufnimmt, und mindestens ein zweites Fach (117), das den mindestens einen elektronischen Schalter (141) aufnimmt, umfasst.

3. Vorrichtung zum elektrischen Erwärmen (100) nach dem vorhergehenden Anspruch, wobei das Innenvolumen (114) des Gehäuses (110) mindestens ein drittes Fach (119) umfasst, in dem eine elektrische Verbindung zwischen dem mindestens einen elektrischen Erwärmungselement (154, 155) und dem mindestens einen elektrischen und/oder elektronischen Bauteil, das von der Leiterplatte (140) getragen wird, ausgeführt ist.

4. Vorrichtung zum elektrischen Erwärmen (100) nach einem der vorhergehenden Ansprüche, wobei die Leiterplatte (140) in ihrer Haupterstreckungsebene (P1) mindestens eine Basis (145), die sich hauptsächlich entlang einer ersten Geraden (D1) erstreckt, und mindestens einen ersten Arm (146) umfasst, der sich hauptsächlich entlang einer zweiten Geraden (D2) erstreckt, die senkrecht oder im Wesentlichen senkrecht zu der ersten Geraden (D1) verläuft.

5. Vorrichtung zum elektrischen Erwärmen (100) nach einem der vorhergehenden Ansprüche, wobei die Leiterplatte (140) eine L-Form aufweist.

6. Vorrichtung zum elektrischen Erwärmen (100) nach Anspruch 4, wobei die Leiterplatte (140) in ihrer Haupterstreckungsebene (P1) mindestens einen zweiten Arm (147) umfasst, der sich hauptsächlich entlang einer dritten Geraden (D3) erstreckt, die senkrecht oder im Wesentlichen senkrecht zu der ersten Geraden (D1) verläuft.

7. Vorrichtung zum elektrischen Erwärmen (100) nach einem der vorhergehenden Ansprüche 1 bis 4 oder 4, wobei die Leiterplatte (140) eine U-Form aufweist.

8. Vorrichtung zum elektrischen Erwärmen (100) nach Anspruch 76 oder nach Anspruch 6 in Kombination mit Anspruch 7, wobei sich der erste Arm (146) der Leiterplatte (140) von einer ersten Seite (145a) der Basis (145) erstreckt und wobei sich der zweite Arm (147) von einer zweiten Seite (145b) der Basis (145) entgegengesetzt der ersten Seite in Bezug auf die erste Gerade (D1) erstreckt.

9. Vorrichtung zum elektrischen Erwärmen (100) nach einem der vorhergehenden Ansprüche in Kombination mit den Ansprüchen 2 oder 3 und 4, wobei die Basis (145) der Leiterplatte (140) gegenüber dem zweiten Fach (117) positioniert ist, und wobei der in der Leiterplatte ausgebildete Ausschnitt (142) gegenüber dem ersten Fach (116) positioniert ist.

## Claims

1. Device (100) for electrically heating a heat transfer liquid, comprising at least one casing (110) defining an internal volume (114) in which at least one circulation chamber (150) for the heat transfer liquid and at least one printed circuit board (140) bearing at least one electric and/or electronic component are received, the circulation chamber (150) for the heat transfer liquid being delimited by at least one external wall (159), the circulation chamber (150) for the heat transfer liquid accommodating at least one electric heating element (154, 155) electrically connected to the at least one electric and/or electronic component borne by the printed circuit board (140), the printed circuit board (140) comprising at least one cutout (142) positioned facing the circulation chamber (150) for the heat transfer liquid, **characterized in that** the circulation chamber (150) at least partially extends through the cutout (142).

2. Electrical-heating device (100) according to Claim 1, wherein at least one electronic switch (141) is received in the internal volume (114) of the casing (110), wherein the internal volume (114) of the casing (110) comprises at least one first compartment (116) which accommodates, at least, the circulation chamber (150) for the heat transfer liquid and at least one second compartment (117) which accommodates the at least one electronic switch (141).

3. Electrical-heating device (100) according to the preceding claim, wherein the internal volume (114) of the casing (110) comprises at least one third compartment (119) in which an electrical connection is made between the at least one electric heating element (154, 155) and the at least one electric and/or electronic component borne by the printed circuit board (140).

4. Electrical-heating device (100) according to any one of the preceding claims, wherein the printed circuit board (140), in its main plane of extent (P1), comprises at least one base (145), which extends mainly in a first straight line (D1), and at least one first arm (146), which extends mainly in a second straight line (D2) perpendicular, or substantially perpendicular, to the first straight line (D1).

5. Electrical-heating device (100) according to any one of the preceding claims, wherein the printed circuit board (140) has an L shape.

6. Electrical-heating device (100) according to Claim 4, wherein the printed circuit board (140), in its main plane of extent (P1), comprises at least one second arm (147), which extends mainly in a third straight line (D3) perpendicular, or substantially perpendicular, to the first straight line (D1).

7. Electrical-heating device (100) according to any one of Claims 1 to 4 or 4, wherein the printed circuit board (140) has a U shape.

8. Electrical-heating device (100) according to Claim 76, or according to Claim 6 taken in combination with Claim 7, wherein the first arm (146) of the printed circuit board (140) extends from a first side (145a) of the base (145), and wherein the second arm (147) extends from a second side (145b) of the base (145) that is opposite the first side with respect to the first straight line (D1).

9. Electrical-heating device (100) according to any one of the preceding claims taken in combination with Claims 2 or 3 and 4, wherein the base (145) of the printed circuit board (140) is positioned facing the second compartment (117), and wherein the cutout (142) formed in the printed circuit board is positioned facing the first compartment (116).
